(19) **Europäisches Patentamt European Patent Office Office européen des brevets**

(11) **EP 2 918 994 B1**

(12) # EUROPEAN PATENT SPECIFICATION

(45) Date of publication and mention
of the grant of the patent:
**24.07.2019 Bulletin 2019/30**

(51) Int Cl.:
***G01N 21/39*** *(2006.01)* ***H01S 5/062*** *(2006.01)*
*G01N 21/3504* *(2014.01)* *H01S 5/183* *(2006.01)*

(21) Application number: **13852550.6**

(22) Date of filing: **07.11.2013**

(86) International application number:
**PCT/CN2013/001344**

(87) International publication number:
**WO 2014/071691 (15.05.2014 Gazette 2014/20)**

(54) **VCSEL-BASED LOW-POWER-CONSUMPTION GAS DETECTION METHOD AND DEVICE**

VCSEL-BASIERTE GASDETEKTIONSVERFAHREN UND -VORRICHTUNG MIT NIEDRIGEM ENERGIEVERBRAUCH

PROCÉDÉ ET DISPOSITIF DE DÉTECTION DE GAZ À BASSE CONSOMMATION ÉNERGÉTIQUE BASÉ SUR UN VCSEL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.11.2012 CN 201210445860**

(43) Date of publication of application:
**16.09.2015 Bulletin 2015/38**

(73) Proprietor: **SHANDONG MICRO-SENSOR PHOTONICS LIMITED**
**Shandong 250101 (CN)**

(72) Inventors:
• **LI, Yanfang**
**Jinan, Shandong 250101 (CN)**
• **LIU, Tongyu**
**Jinan, Shandong 250101 (CN)**
• **WEI, Yubin**
**Jinan, Shandong 250101 (CN)**
• **WANG, Chang**
**Jinan, Shandong 250101 (CN)**
• **ZHAO, Yanjie**
**Jinan, Shandong 250101 (CN)**
• **ZHANG, Tingting**
**Jinan, Shandong 250101 (CN)**
• **ZHAO, Weisong**
**Jinan, Shandong 250101 (CN)**

(74) Representative: **Office Kirkpatrick**
**Avenue Wolfers, 32**
**1310 La Hulpe (BE)**

(56) References cited:
WO-A1-03/069316     CN-A- 101 153 860
CN-A- 101 251 482     CN-A- 101 405 969
CN-A- 101 514 961     CN-A- 101 532 951
CN-A- 102 967 580     JP-A- 2009 174 920
US-A1- 2002 064 193     US-B1- 7 218 388

• **WEI YUBIN ET AL: "High-resolution fiber methane sensor based on diode laser and its data processing", INTERNATIONAL SYMPOSIUM ON PHOTOELECTRONIC DETECTION AND IMAGING 2011: LASER SENSING AND IMAGING; AND BIOLOGICAL AND MEDICAL APPLICATIONS OF PHOTONICS SENSING AND IMAGING, SPIE, 1000 20TH ST. BELLINGHAM WA 98225-6705 USA, vol. 8192, no. 1, 9 June 2011 (2011-06-09), pages 1-6, XP060016411, DOI: 10.1117/12.900865 [retrieved on 1901-01-01]**
• **BENJAMIN KOGEL ET AL: "Simultaneous Spectroscopy of NH and CO Using a Continuously Tunable MEMS-VCSEL", IEEE SENSORS JOURNAL, IEEE SERVICE CENTER, NEW YORK, NY, US, vol. 7, no. 11, November 2007 (2007-11), pages 1483-1489, XP011192396, ISSN: 1530-437X, DOI: 10.1109/JSEN.2007.907055**
• Jia Chen: "Compact laser-spectroscopic gas sensors using vertical-cavity surface-emitting lasers", , June 2011 (2011-06), pages 1-166, XP055287980, ISBN: 978-3-941650-30-5 Retrieved from the Internet: URL:https://mediatum.ub.tum.de/doc/998325/998325.pdf [retrieved on 2016-07-13]**

• NI, JIASHENG ET AL.: 'Application of optical fibre gas sensor in mining safety of coal mine' PROCEEDINGS OF THE 2007 ACADEMIC ANNUAL CONFERENCE OF CHINA OCCUPATIONAL SAFETY AND HEALTH ASSOCIATION 30 November 2007, pages 514 - 516, XP008179246

**Description**

**Field of the Invention**

The present invention relates to the field of optical fiber sensing, and particularly relates to a VCSEL-based gas detection method and device with low power consumption.

**Background of the Invention**

With the continuous development of industrial and agricultural production technology, timely and accurate monitoring of a variety of gases has become an important problem to be urgently solved in such industries as petroleum, chemical engineering, electric power, coal mine safety and the like. Meanwhile, with the continuous improvement of the living standards of people, the requirements of people on the ecological environment are increasingly higher, environmental protection is paid attention to with the urgent requirements of development, and the environment is monitored and governed. Therefore, the development of gas sensors has become an important issue in the current sensing field.

The optical fiber gas detection technology appeared in the 1980s is a novel gas detection method, and has the advantages of high measurement accuracy, wide measurement range, long transmission distance, strong anti-electromagnetic interference capability, good gas selectivity, long service life and the like which are incomparable by the traditional gas detection method. Especially, with the continuous development of laser technology, laser gas sensors have been greatly developed and are mentioned in a plurality of patents. But in the method, a DFB laser or a VCSEL laser requires precise temperature control, and the power consumption of a Thermoelectric Cooler(TEC) controller is very large, so that the power consumption of this kind of sensors is generally larger, the starting current of the instrument is very large in particular, and some even is up to 500mAs, resulting in that this kind of sensors is unlikely to meet the requirements of underground intrinsic safety parameters of coal mines and is unfavorable to be directly used with such existing mining equipment as a base station and the like. This is a fatal defect in preventing the promotion and application of this kind of instruments underground coal mines.

According to the Chinese patent "GAS DETECTION METHOD AND GAS DETECTION DEVICE", a light source requires precise temperature control when gases are measured by the square spectrum absorption method, and since the TEC is used for controlling the temperature of the light source, the power consumption for implementing the measurement method is particularly large. TEC is omitted in the present application to reduce the power consumption, and meanwhile a reference channel is provided to improve the measurement accuracy.

The document WEI YUBIN ET AL: "High-resolution fiber methane sensor based on diode laser and its data processing", INTERNATIONAL SYMPOSIUM ON PHOTOELECTRONIC DETECTION AND IMAGING 2011: LASER SENSING AND IMAGING; AND BIOLOGICAL AND MEDICAL APPLICATIONS OF PHOTONICS SENSING AND IMAGING, SPIE, 1000 20TH ST. BELLINGHAM WA 98225-6705 USA, vol. 8192, no. 1, 9 June 2011 (2011-06-09), pages 1-6,DOI: 10.1117/12.900865 and documents CN 101 514 961 A and CN 101 251 482 A disclose gas detection devices comprising splitter-coupler-arrangements and fiber probes and using DFB lasers with active temperature control.

The document BENJAMIN KOGEL ET AL: "Simultaneous Spectroscopy of NH and CO Using a Continuously Tunable MEMS-VCSEL",IEEE SENSORS JOURNAL, IEEE SERVICE CENTER, NEW YORK, NY, US, vol. 7, no. 11, 1 November 2007 (2007-11-01), pages 1483-1489, ISSN: 1530-437X, DOI: 10.1109/JSEN.2007.907055, the document WO 03/069316 A1 and the document Jia Chen: "Compact laser-spectroscopic gas sensors using vertical-cavity surface-emitting lasers",Dissertation, June 2011 (2011-06), pages 1-166, ISBN: 978-3-941650-30-5 disclose VCSELS used as tunable diode lasers in absorption spectroscopy.

**Summary of the Invention**

The purpose of the present invention is to overcome the above-mentioned problems and provide a VCSEL-based gas detection method and device with low power consumption, which have the advantages of detecting gas concentration in low power consumption.

To fulfill the above-mentioned purpose, the present invention adopts the technical solution defined in claim 1.

The VCSEL laser is a laser for performing continuous wavelength modulation through current; the VCSEL laser is a VCSEL laser without TEC, and the wavelength of the VCSEL laser and the environmental temperature basically form a linear relationship under the condition of consistent drive current.

A working method adopted by the above-mentioned VCSEL-based gas detection device with low power consumption is defined in claim 3.

The beneficial effects of the present invention are as follows:

1. The wavelength of the VCSEL laser is accurately controlled without using a temperature control system, so that the power consumption of the sensor is greatly reduced, and the VCSEL laser is possible to promote underground in large scales.

2. The VCSEL laser is driven by current changing within a certain range to ensure a very large scanning range of the wavelength of the light source.

3. The gas detection method provided by the present invention can be used for simultaneously detecting the environmental temperature and judging the approximate wavelength of the light emitted by the light source through the environmental temperature, so as to determine the wavelength of the absorption peak of the gas to be measured and detect the concentration of the gas to be measured.

4. Meanwhile, temperature compensation can also be introduced by testing the environmental temperature to improve the measurement accuracy and reliability.

5. The wavelength and the power reference are introduced in the measurement method provided by the present invention at the same time to improve the measurement accuracy.

6. When measuring other gases, only the VCSEL laser is changed, as long as the central wavelength of the VCSEL laser is mated with the wavelength of the absorption peak of the gas to be measured, a variety of gases can be detected. The method is simple and reliable and greatly promotes the development of optical fiber gas sensing.

**Brief Description of the Drawings**

Fig. 1     is a schematic diagram of gas detection with low power consumption;
Fig. 2     is a diagram of a methane absorption signal;
Fig. 3     is a diagram of a methane absorption spectral line;
Fig. 4     is a diagram of an acetylene absorption spectral line;
Fig. 5     is a diagram of a carbon dioxide absorption spectral line;

wherein, 1 represents a VCSEL laser, 2 represents a splitter, 3 represents a first coupler, 4 represents an optical fiber sensing probe, 5 represents a first photoelectric detector, 6 represents a second coupler, 7 represents a reference probe, 8 represents a second photoelectric detector, 9 represents a third photoelectric detector and 10 represents a temperature detection device.

**Detailed Description of the Embodiments**

The embodiments of the present invention will be described below in detail, with methane as an example and in combination with the detection accompanying drawings:

a VCSEL-based gas detection device with low power consumption includes a temperature detection device 10, a VCSEL laser 1, an optical path component, an optical fiber sensing probe 4, a reference probe 7, photoelectric detectors and a reference power detection device, wherein the optical path component includes a splitter 2 and couplers; the temperature detection device 10 is connected with the VCSEL laser 1, the VCSEL laser 1 is connected with the splitter 2 of the optical path component, the splitter 2 is connected with the input end of a first coupler 3 and the input end of a second coupler 6, the output end of the first coupler 3 is connected with the optical fiber sensing probe 4, and the return end of the first coupler 3 is connected with a first photoelectric detector 5; the output end of the second coupler 6 is connected with the reference probe 7 and the reference power detection device; the reference probe 7 is connected with a second photoelectric detector 8; the reference power detection device is a third photoelectric detector, and the light emitted by the VCSEL laser 1 enters the optical fiber sensing probe 4, the reference probe 7 and the reference power detection device after being isolated and split by the optical path component.

The VCSEL laser 1 is a laser for performing continuous wavelength modulation through current; the VCSEL laser 1 is a VCSEL laser- without TEC, and the wavelength of the VCSEL laser 1 and the environmental temperature basically form a linear relationship under the condition of consistent drive current.

The wavelength of the VCSEL laser 1 is sensitive to the temperature and the drive current, the temperature modulation coefficient $\beta_1$ of the wavelength is relatively small, and the current modulation coefficient $\beta_2$ of the wavelength is relatively large. In the embodiment, sawtooth drive current (generally changing from threshold current to the maximum drive circuit) with a fixed frequency is used for modulating the wavelength of the VCSEL laser within a larger range, but the VCSEL laser 1 contains no TEC the change of the environmental temperature generates a larger influence on the change of the wavelength of the VCSEL laser, during detection, the scanning range of the wavelength of the light source is approximately judged through the environmental temperature to determine the wavelength of an absorption peak scanned by the light source, and the concentration of the gas is measured through the Beer-Lambert law.

According to the Beer-Lambert law, when the wavelength is $\lambda$, and when light with an initial light intensity of

$I_0(\lambda)$ irradiates a certain gas, due to resonance absorption, the initial light intensity $I_0(\lambda)$ and the emission light intensity $I(\lambda)$ satisfy the following relationship:

$$I(\lambda) = I_0(\lambda)\exp(-\alpha CL)$$

wherein $I_0(\lambda)$ refers to the initial light intensity of the system, $I(\lambda)$ refers to the emission light intensity of the system, $\alpha$ refers to the absorption coefficient of the measured gas, the coefficient is related to the environmental temperature, the pressure and the wavelength of the light source, C refers to the concentration of the measured gas, and L refers to the effective length of a probe absorption cavity of the measured gas.

Taking the dissipation of the optical path and the like into consideration, the Beer-Lambert law can be modified to the following formula:

$$I(\lambda) = KI_0(\lambda)\exp(-\alpha CL) \quad (1)$$

wherein K refers to a dissipation coefficient
inverse solution is carried out on the above formula to obtain the following formula:

$$C = \ln\left(\frac{KI_0(\lambda)}{I(\lambda)}\right)\Big/\alpha L \quad (2)$$

It can be seen from the above formula that the concentration of the measured gas can be measured by measuring the light intensity and optical distances before and after emission. Since the optical distance of the system is a fixed value, we just need to measure the change of the light intensity before and after emission to measure the concentration of the measured methane.

In an actual measurement process, with the change of the environmental temperature, the central wavelength of the light emitted by the VCSEL laser 1 changes continuously. It is assumed that when the environmental temperature is T °C, the central wavelength of the VCSEL laser 1 is $\lambda$, the wavelengths corresponding to two absorption peaks of the methane gas near the wavelength are respectively $\lambda_1$ and $\lambda_2$, the change of the drive current of the light source is $\Delta I$, the wavelength range capable of being scanned by the current is $\Delta\lambda_I$, the change of the environmental temperature is $\Delta T$, and the wavelength change range caused by the environmental temperature is $\Delta\lambda_T$. If the wavelength and the change of the VCSEL laser 1 satisfy the following formula:

$$\Delta\lambda_I > \lambda_1 + \lambda_2 - \lambda \quad (3)$$

and the temperature modulation coefficient $\beta_1$ and the current modulation coefficient $\beta_2$ of the wavelength satisfy the following formula:

$$\beta_2 < \frac{\Delta I}{\Delta T}\beta_1 \quad (4)$$

then, within the entire temperature change range, the VCSEL laser 1 can always scan at least one absorption peak, and the wavelengths corresponding to the absorption peaks scanned by the VCSEL laser 1 under different environments can be determined in combination with an environmental temperature value measured by a temperature test unit.

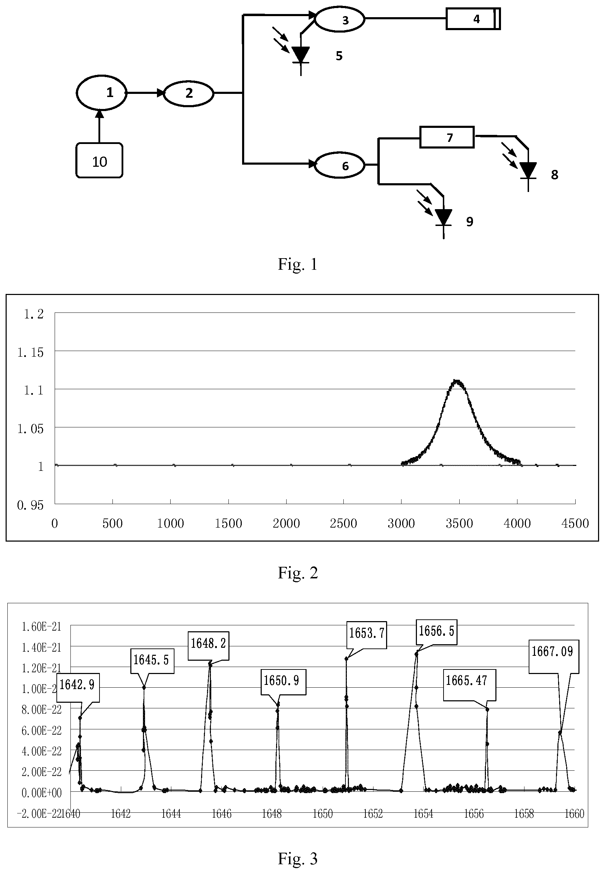

The first photoelectric detector 5, the second photoelectric detector 8 and the third photoelectric detector 9 are all InGaAs photoelectric detectors, the output current thereof forms a certain linear relationship with the light intensity of the photoelectric detectors, therefore in a photoelectric detection circuit, a voltage signal output after passing through an operational amplifier forms a linear relationship with the light intensity of the light entering the photoelectric detectors. The signal obtained by a power reference channel is respectively divided by signals obtained by a detection channel and a wavelength reference channel to obtain signals as shown in Fig. 2, and the method can be used for removing the influence of the change of the light intensity on the measurement result. By means of the signals of the reference channels, we can obtain the detailed position of the absorption peak in the entire scanning period, as shown by the curved line in Fig. 2, after the position is determined, the collected detection signal is processed by a microprocessor, and we can obtain the concentration of the measured methane gas according to the Beer-Lambert law.

Fig. 3 shows an absorption spectral line of methane, it can be seen from Fig. 3 that the VCSEL laser 1 satisfying the above-mentioned method can be found between 1645.5nm and 1648.2nm and between 1650.9nm and 1653.7nm, namely, the method can be used for detecting the concentration of methane.

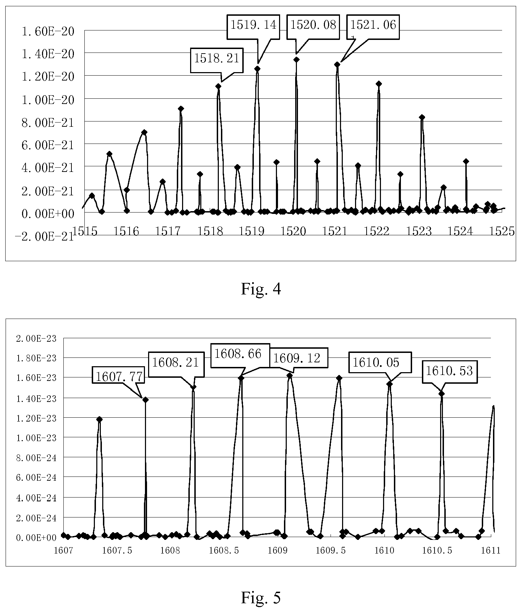

Fig. 4 shows an absorption spectral line of acetylene, it can be seen from Fig. 4 that a proper VCSEL laser 1 can be found between 1518.21nm and 1519.14nm, between 1519.14nm and 1520.8nm or between two other adjacent wavelengths to satisfy the above-mentioned measurement method, in order to detect the acetylene gas.

Fig. 5 shows an absorption spectral line of carbon dioxide, it can be seen from Fig. 5 that a proper VCSEL laser 1 can be found between 1507.77nm and 1508.21nm, between 1508.21nm and 1508.66nm or between two other adjacent wavelengths to satisfy the above-mentioned measurement method, in order to detect the acetylene gas.

The several examples mentioned above are merely examples listed for illustrating the method and are not all the examples of achieving the method provided by the present invention, with respect to different gases, the wavelengths corresponding to the absorption peaks are different, and only the VCSEL laser 1 is replaced to detect the gas concentration by adopting a similar method.

**Claims**

1. A VCSEL-based gas detection device with low power consumption, comprising a temperature detection device (10), a VCSEL (1) without a temperature control module, optical path components, an optical fiber sensing probe (4), a reference probe (7), a first photoelectric detector (5), a second photoelectric detector (8) and a third photoelectric detector which is a reference power detection device (9), wherein the optical path components comprise a splitter (2) and couplers (3,6); the temperature detection device (10) is connected with the VCSEL (1), the VCSEL (1) is connected with the splitter (2) of the optical path components, the splitter (2) is connected with the input end of a first coupler (3) and the input end of a second coupler (6), the output end of the first coupler (3) is connected with the optical fiber sensing probe (4), and the return end of the first coupler (3) is connected with the first photoelectric detector (5) such that light is detected by the first photoelectric detector (5) after passing through the optical fiber sensing probe (4); the second coupler (6) comprises two output ends; the first output end of the second coupler (6) is connected with an input end of the reference probe (7) and the second output end of the second coupler (6) is connected with the reference power detection device (9); an output end of the reference probe (7) is connected with the second photoelectric detector (8); the light emitted by the VCSEL (1) enters the optical fiber sensing probe (4) via the first coupler (3), the reference probe (7) via the second coupler (6) and the reference power detection device (9) via the second coupler (6) after being isolated and split by the optical path components.

2. The VCSEL-based gas detection device with low power consumption of claim 1, wherein the VCSEL (1) is a laser for performing continuous wavelength modulation through current; the wavelength of the VCSEL and the environmental temperature form a linear relationship under the condition of consistent drive current.

3. A working method adopted by the VCSEL-based gas detection device with low power consumption of claim 1 or 2, comprising the following working steps:

   step (1): the temperature detection device (10) measures the environmental temperature;
   step (2): the wavelength of the light emitted by the laser is determined according to the environmental temperature measured in step (1);
   step (3): the wavelength of an absorption peak occurring in a scanning range is determined according to the wavelength of the laser determined in step (2);
   step (4): the VCSEL (1) emits light, and the wavelength of said light and the environmental temperature form a linear relationship under the condition of consistent drive current;
   step (5): the light emitted by the VCSEL (1) enters the optical fiber sensing probe (4), the reference probe (7) and the reference power detection device (9) through the optical path components such that:

      step (5-1): the light emitted by the VCSEL (1) is absorbed in the optical fiber sensing probe (4) to a certain extent, the absorption strength is a function according to Beer Lambert law of the concentration of a gas to be measured in the environment, and the light is detected by the first photoelectric detector (5) after passing through the optical fiber sensing probe (4) to output a voltage signal after passing through an operational amplifier which is a function of the concentration of the gas to be detected;
      step (5-2): the light emitted by the VCSEL (1) is fixedly absorbed in the reference probe (7), the absorption strength is related to the concentration of the gas in a reference gas chamber, and the light is detected by the second photoelectric detector (8) after passing through the reference probe (7) to output a voltage signal after passing through an operational amplifier which is a function of the concentration of gas in a reference gas chamber; and

step (5-3): the light emitted by the VCSEL (1) enters the reference power detection device (9) through the splitter (2) to output a power reference signal;

step (6): the two detection signals obtained in steps (5-1) and (5-2) are respectively divided by the power reference signal obtained in step (5-3), in order to eliminate the influence of power change of the light source on a measurement result;

step (7): the position of the absorption peak in the entire scanning period is determined according to step (3) and step (6); and

step (8): the signal carrying concentration information and obtained in step (6) for eliminating the influence of the power change of the VCSEL (1) on the measurement result is compared with a concentration signal in the reference probe with reference to the position of the absorption peak determined in step (7) and in accordance with the Beer-Lambert law to measure the concentration of the gas to be measured.

**Patentansprüche**

1. VCSEL-basierte Gasdetektionsvorrichtung mit geringem Energieverbrauch, umfassend eine Temperaturdetektionsvorrichtung (10), einen VCSEL (1) ohne Temperatursteuermodul, Lichtwegkomponenten, eine Lichtleitfaser-Messsonde (4), eine Referenzsonde (7), einen ersten photoelektrischen Detektor (5), einen zweiten photoelektrischen Detektor (8) und einen dritten photoelektrischen Detektor, der eine Referenzenergiedetektionsvorrichtung (9) ist, wobei

die Lichtwegkomponenten einen Teiler (2) und Koppler (3, 6) umfassen;
die Temperaturdetektionsvorrichtung (10) mit dem VCSEL (1) verbunden ist, der VCSEL (1) mit dem Teiler (2) der Lichtwegkomponenten verbunden ist, der Verteiler (2) mit dem Eingangsende eines ersten Kopplers (3) und dem Eingangsende eines zweiten Kopplers (6) verbunden ist, das Ausgangsende des ersten Kopplers (3) mit der Lichtleitfaser-Messsonde (4) verbunden ist, und das Rückführungsende des ersten Kopplers (3) mit dem ersten photoelektrischen Detektor (5) verbunden ist, so dass Licht durch den ersten photoelektrischen Detektor (5) detektiert wird, nachdem es durch die Lichtleitfaser-Messsonde (4) gegangen ist;
der zweite Koppler (6) zwei Ausgangsenden umfasst;
das erste Ausgangsende des zweiten Kopplers (6) mit einem Eingangsende der Referenzsonde (7) verbunden ist, und das zweite Ausgangsende des zweiten Kopplers (6) mit der Referenzenergiedetektionsvorrichtung (9) verbunden ist;
ein Ausgangsende der Referenzsonde (7) mit dem zweiten photoelektrischen Detektor (8) verbunden ist;
das Licht, das durch den VCSEL (1) emittiert wird, in die Lichtleitfaser-Messsonde (4) über den ersten Koppler (3), in die Referenzsonde (7) über den zweiten Koppler (6) und in die Referenzenergiedetektionsvorrichtung (9) über den zweiten Koppler (6) eintritt, nachdem es durch die Lichtwegkomponenten isoliert und geteilt wurde.

2. VCSEL-basierte Gasdetektionsvorrichtung mit geringem Energieverbrauch nach Anspruch 1, wobei
der VCSEL (1) ein Laser zum Ausführen einer kontinuierlichen Wellenlängenmodulation durch Strom ist;
die Wellenlänge des VCSEL und die Umgebungstemperatur unter der Voraussetzung eines gleichbleibenden Antriebsstroms eine lineare Beziehung bilden.

3. Arbeitsverfahren, das durch die VCSEL-basierte Gasdetektionsvorrichtung mit geringem Energieverbrauch nach Anspruch 1 oder 2 übernommen wird, umfassend die folgenden Arbeitsschritte:

Schritt (1): die Temperaturdetektionsvorrichtung (10) misst die Umgebungstemperatur;
Schritt (2) : die Wellenlänge des Lichts, das durch den Laser emittiert wird, wird gemäß der in Schritt (1) gemessenen Umgebungstemperatur bestimmt;
Schritt (3): die Wellenlänge einer Absorptionsspitze, die in einem Abtastbereich vorkommt, wird gemäß der Wellenlänge des in Schritt (2) bestimmten Lasers bestimmt;
Schritt (4): der VCSEL (1) emittiert Licht, und die Wellenlänge des Lichts und die Umgebungstemperatur bilden unter der Voraussetzung eines gleichbleibenden Antriebsstroms eine lineare Beziehung;
Schritt (5): das Licht, das durch den VCSEL (1) emittiert wird, tritt über den Lichtleitweg in die Lichtleitfaser-Messsonde (4), die Referenzsonde (7) und die Referenzenergiedetektionsvorrichtung (9) ein, so dass:

Schritt (5-1) : das Licht, das durch den VCSEL (1) emittiert wird, in der Lichtleitfaser-Messsonde (4) in gewissem Maße absorbiert wird, wobei die Absorptionsstärke eine Funktion gemäß dem Lambert-Beerschen Gesetz der Konzentration eines in der Umgebung zu messenden Gases ist, und das Licht durch den ersten photoelektrischen Detektor (5) detektiert wird, nachdem es durch die Lichtleitfaser-Messsonde (4) gegangen ist, um, nachdem es durch einen Operationsverstärker gegangen ist, ein Spannungssignal auszugeben, das eine Funktion der Konzentration des zu detektierenden Gases ist;

Schritt (5-2) : das Licht, das durch den VCSEL (1) emittiert wird, in der Referenzsonde (7) unveränderlich absorbiert wird, die Absorptionsstärke mit der Konzentration des Gases in einer Referenzgaskammer zusammenhängt, und das Licht durch den zweiten photoelektrischen Detektor (8) detektiert wird, nachdem es durch die Referenzsonde (7) gegangen ist, um, nachdem es durch einen Operationsverstärker gegangen ist, ein Spannungssignal auszugeben, das eine Funktion der Konzentration von Gas in einer Referenzgaskammer ist; und

Schritt (5-3): das Licht, das durch den VCSEL (1) in die Referenzenergiedetektionsvorrichtung (9) emittiert wird, durch den Teiler (2) in die Referenzenergiedetektionsvorrichtung (9) eintritt, um ein Energiereferenzsignal auszugeben;

Schritt (6) : die beiden Detektionssignale, die in den Schritten (5-1) und (5-2) erzielt werden, werden jeweils durch das in Schritt (5-3) erzielte Energiereferenzsignal dividiert, um den Einfluss einer Energieänderung der Lichtquelle auf ein Messergebnis aufzuheben;

Schritt (7) : die Position der Absorptionsspitze in der gesamten Abtastperiode wird gemäß Schritt (3) und Schritt (6) bestimmt; und

Schritt (8): das Signal, das Konzentrationsinformationen übermittelt und in Schritt (6) zum Aufheben des Einflusses der Energieänderung des VCSEL (1) auf das Messergebnis erzielt wird, wird mit einem Konzentrationssignal in der Referenzsonde mit Bezug auf die Position der in Schritt (7) bestimmten Absorptionsspitze und gemäß dem Lambert-Beerschen Gesetz verglichen, um die Konzentration des zu messenden Gases zu messen.

## Revendications

1. Dispositif de détection de gaz basé sur un VCSEL à faible consommation d'énergie, comprenant un dispositif de détection de température (10), un VCSEL (1) sans module de commande de température, des composants de chemin optique, une sonde de détection à fibre optique (4), une sonde de référence (7), un premier détecteur photoélectrique (5), un deuxième détecteur photoélectrique (8) et un troisième détecteur photoélectrique qui sert de dispositif de détection de puissance de référence (9), les composants de chemin optique comprenant un séparateur (2) et des coupleurs (3, 6) ; le dispositif de détection de température (10) est connecté au VCSEL (1), le VCSEL (1) est connecté au séparateur (2) des composants de chemin optique, le séparateur (2) est connecté à l'extrémité d'entrée d'un premier coupleur (3) et à l'extrémité d'entrée d'un second coupleur (6), l'extrémité de sortie du premier coupleur (3) est connectée à la sonde de détection à fibre optique (4), et l'extrémité de retour du premier coupleur (3) est connectée au premier détecteur photoélectrique (5) de façon que la lumière soit détectée par le premier détecteur photoélectrique (5) après être passée par la sonde de détection à fibre optique (4) ; le second coupleur (6) comprend deux extrémités de sortie ; la première extrémité de sortie du second coupleur (6) est connectée à une extrémité d'entrée de la sonde de référence (7) et la seconde extrémité de sortie du second coupleur (6) est connectée au dispositif de détection de puissance de référence (9) ; une extrémité de sortie de la sonde de référence (7) est connectée au deuxième détecteur photoélectrique (8) ; la lumière émise par le VCSEL (1) entre dans la sonde de détection à fibre optique (4) via le premier coupleur (3), dans la sonde de référence (7) via le second coupleur (6) et dans le dispositif de détection de puissance de référence (9) via le second coupleur (6) après avoir été isolée et divisée par les composants de chemin optique.

2. Dispositif de détection de gaz basé sur un VCSEL à faible consommation d'énergie selon la revendication 1, dans lequel le VCSEL (1) est un laser destiné à effectuer une modulation de longueur d'onde continue par courant ; la longueur d'onde du VCSEL et la température environnementale forment une relation linéaire dans des conditions de courant d'excitation constant.

3. Procédé de fonctionnement adopté par le dispositif de détection de gaz basé sur un VCSEL à faible consommation d'énergie selon la revendication 1 ou 2, comprenant les étapes suivantes :

Étape 1 : le dispositif de détection de température (10) mesure la température environnementale ;
Étape 2 : la longueur d'onde de la lumière émise par le laser et déterminée en fonction de la température environnementale mesurée à l'étape 1 ;

Étape 3 : la longueur d'onde d'un pic d'absorption survenant dans une gamme de balayage est déterminée en fonction de la longueur d'onde du laser déterminée à l'étape (2) ;

Étape 4 : le VCSEL (1) émet de la lumière, et la longueur d'onde de ladite lumière et la température environnementale forment une relation linéaire dans des conditions de courant d'excitation constant ;

Étape 5 : la lumière émise par le VCSEL (1) entre dans la sonde de détection à fibre optique (4), la sonde de référence (7) et le dispositif de détection de puissance de référence (9) par le chemin optique, de façon que :

Étape 5-1 : la lumière émise par le VCSEL soit absorbée dans la sonde de détection à fibre optique (4) dans une certaine mesure, l'intensité de l'absorption est fonction de la loi de Beer Lambert sur la concentration en un gaz à mesurer dans l'environnement, et la lumière est détectée par le premier détecteur photoélectrique (5) après être passée par la sonde de détection à fibre optique (4) pour produire un signal en tension, après passage par un amplificateur opérationnel, qui est une fonction de la concentration du gaz à détecter ;

Étape 5-2 : la lumière émise par le VCSEL (1) est absorbée de façon fixe par la sonde de référence (7), l'intensité de l'absorption est liée à la concentration du gaz dans une chambre de gaz de référence, et la lumière est détectée par le deuxième détecteur photoélectrique (8) après passage par la sonde de référence (7) pour produire un signal en tension, après passage par un amplificateur opérationnel, qui est une fonction de la concentration en gaz dans la chambre de gaz de référence ; et

Étape 5-3 : la lumière émise par le VCSEL (1) entre dans le dispositif de détection de puissance de référence (9) à travers un séparateur (2) pour produire un signal de référence en puissance ;

Étape 6 : les deux signaux de détection obtenues aux étapes 5-1 et 5-2 sont respectivement divisées par le signal de référence en puissance obtenu à l'étape 5-3 pour éliminer l'influence du changement de puissance de la source de lumière sur un résultat de mesure ;

Étape 7 : la position du pic d'absorption sur toute la période de balayage est déterminée selon l'étape 3 et l'étape 6 ; et

Étape 8 : le signal porteur des informations de concentration et obtenu à l'étape 6 pour éliminer l'influence du changement de puissance du VCSEL (1) sur le résultat de mesure et comparé à un signal de concentration dans la sonde de référence en prenant référence sur la position du pic d'absorption déterminée à l'étape 7 et selon la loi de Beer Lambert pour mesurer la concentration du gaz à mesurer.

Fig. 1

Fig. 2

Fig. 3

Fig. 4

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 101514961 A
- CN 101251482 A

- WO 03069316 A1

**Non-patent literature cited in the description**

- High-resolution fiber methane sensor based on diode laser and its data processing. **WEI YUBIN et al.** INTERNATIONAL SYMPOSIUM ON PHOTOELECTRONIC DETECTION AND IMAGING 2011: LASER SENSING AND IMAGING; AND BIOLOGICAL AND MEDICAL APPLICATIONS OF PHOTONICS SENSING AND IMAGING. SPIE, 09 June 2011, vol. 8192, 1-6

- Simultaneous Spectroscopy of NH and CO Using a Continuously Tunable MEMS-VCSEL. **BENJAMIN KOGEL et al.** IEEE SENSORS JOURNAL. IEEE SERVICE CENTER, 01 November 2007, vol. 7, 1483-1489
- **JIA CHEN.** Compact laser-spectroscopic gas sensors using vertical-cavity surface-emitting lasers. *Dissertation,* June 2011, ISBN 978-3-941650-30-5, 1-166